(19) Europäisches Patentamt
European Patent Office
Office européen des brevets

(11) EP 2 846 396 A1

(12) **EUROPEAN PATENT APPLICATION**
published in accordance with Art. 153(4) EPC

(43) Date of publication:
**11.03.2015 Bulletin 2015/11**

(21) Application number: **13784534.3**

(22) Date of filing: **24.04.2013**

(51) Int Cl.:
***H01M 14/00*** *(2006.01)* ***H01L 31/04*** *(2014.01)*

(86) International application number:
**PCT/JP2013/062039**

(87) International publication number:
**WO 2013/164967 (07.11.2013 Gazette 2013/45)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **01.05.2012 JP 2012104567**

(71) Applicant: **Sharp Kabushiki Kaisha**
**Osaka-shi, Osaka 545-8522 (JP)**

(72) Inventors:
- **FUKUI, Atsushi**
  **Osaka-shi**
  **Osaka 545-8522 (JP)**
- **KOMIYA, Ryoichi**
  **Osaka-shi**
  **Osaka 545-8522 (JP)**
- **YAMANAKA, Ryohsuke**
  **Osaka-shi**
  **Osaka 545-8522 (JP)**

(74) Representative: **Müller Hoffmann & Partner**
**Patentanwälte**
**St.-Martin-Strasse 58**
**81541 München (DE)**

# (54) PHOTOELECTRIC CONVERSION ELEMENT AND PHOTOELECTRIC CONVERSION MODULE

(57) Provided is a photoelectric conversion element where the photoelectric conversion efficiency is improved.

In the photoelectric conversion element, a first region where a photoelectric conversion layer is provided on the conductive layer and a second region where a photoelectric conversion layer is not provided on the conductive layer interpose a scribe line section which is configured without the conductive layer being provided on the support material. An inter-cell insulation layer is provided on the scribe line section. A counter conductive layer is connected with the conductive layer in the second region by extending to the second region by passing over the inter-cell insulation layer from the first region. The line width of the scribe line section is 60 μm or more.

FIG. 1

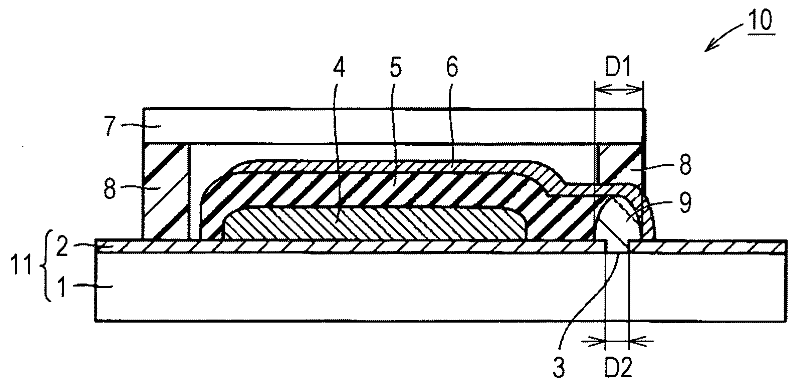




Printed by Jouve, 75001 PARIS (FR)

## Description

### Technical Field

The present invention relates to a photoelectric conversion element and a photoelectric conversion module.

### Background Art

Solar cells which convert sunlight into electricity have attracted attention as an energy source to replace fossil fuels. Currently, solar cells using crystalline silicon substrates, thin-film silicon solar cells, and the like are being put into practical use. However, in the solar cells using crystalline silicon substrates, there is a problem in that the manufacturing costs of the silicon substrates are high. In the thin-film silicon solar cells, there is a problem in that the manufacturing costs are high since it is necessary to use various types of gases for semiconductor manufacturing and complex apparatuses. For this reason, in both of the solar cells, efforts to reduce the costs of the electric power output by increasing the efficiency of photoelectric conversion are continuing; however, the problems described above have not been solved.
PTL 1 proposes a photoelectric conversion element applying photo-induced electron movement of a metal complex as a new type of solar cell. In the photoelectric conversion element, a photoelectric conversion layer formed of a photoelectric conversion material, which adsorbs a coloring dye thereon so as to have an absorption spectrum in the visible light region, and an electrolyte material is interposed between two electrodes, and both of the electrodes are configured by forming a transparent conductive film on the surface of a glass substrate.
When light is received by the photoelectric conversion element described above, electrons are generated in the photoelectric conversion layer, and the electrons which are generated move to the electrode by passing through an external electric circuit, the electrons which are moved return to the photoelectric conversion layer by being carried to the opposing electrode by ions in the electrolytes. In this manner, electrical energy is produced due to the flow of electrons in series.
As described above, the basic structure of the photoelectric conversion elements described in PTL 1 has a form where an electrolytic solution is introduced between opposing glass substrates with attached transparent conductive films. Therefore, even though it is possible to manufacture the photoelectric conversion elements described above with a small area, it is difficult to apply the photoelectric conversion element described in PTL 1 to a solar cell with a large area such as 1 m square. That is, when the area of one solar cell increases, the generated current increases since the generated current is in proportion to the area; however, the voltage drop increases in the in-plane direction of the transparent conductive film used in the electrode portion and the internal series resistance as the solar cell increases. As a result, there are problems in that the FF (fill factor) in the current voltage characteristics during photoelectric conversion decreases, moreover, the short-circuit current decreases, and the photoelectric conversion efficiency decreases.
PTL 2 and PTL 3 propose a coloring dye-sensitized solar cell module which is configured by connecting a plurality of solar cells in series on one glass substrate with an attached transparent conductive film. In this coloring dye-sensitized solar cell module, individual solar cells are arranged on a transparent substrate (a glass substrate) where a transparent conductive film (electrode) is patterned with a strip shape, and a porous semiconductor layer (a porous titanium oxide layer) which is a photoelectric conversion layer, a porous insulation layer (an intermediate porous insulation layer), and a counter electrode (a catalyst layer) are laminated in sequence in the individual solar cells. In the coloring dye-sensitized solar cell module, the transparent conductive film of one solar cell out of adjacent solar cells and the counter electrode of the other solar cell are in contact and the one solar cell and the other solar cell are connected in series due to this.

### Citation List

### Patent Literature

PTL 1: Japan Patent Publication "Japanese Unexamined Patent Application Publication No. 01-220380 (published September 4th, 1989)"
PTL 2: Pamphlet of International Publication WO. 1997/016838 (published May 9th, 1997)"
PTL 3: Japan Patent Publication "Japanese Unexamined Patent Application Publication No. 2002-367686 (published December 20th, 2002)"

Summary of Invention

Technical Problem

Here, in the photoelectric conversion element such as the coloring dye-sensitized solar cell, there is a problem in that durability is reduced due to external environmental factors such as light, heat, and humidity. Due to this, a decrease in the photoelectric conversion efficiency, which is estimated to be caused by an increase in reverse current, may be seen. In particular, in a case where heat stress is applied to a monolithic type wet solar cell (wet solar cell module), the performance degradation for which an increase in the reverse current is viewed as a factor is remarkable.

The present invention was made in consideration of the problem described above and has an object of providing a photoelectric conversion element where an increase in the reverse current is suppressed and thus the photoelectric conversion efficiency is improved.

Solution to Problem

A photoelectric conversion element according to the present invention is provided with a support material formed of a material with a light transmitting property, a conductive layer, a photoelectric conversion layer which includes a porous semiconductor layer, a porous insulation layer, and a counter conductive layer, which are provided in sequence on the support material. Respective interval portions in the porous semiconductor layer, the porous insulation layer, and the counter conductive layer are filled with a carrier transporting material. A first region where a photoelectric conversion layer is provided on the conductive layer and a second region where a photoelectric conversion layer is not provided on the conductive layer interpose therebetween a scribe line section which is configured without the conductive layer being provided on the support material. An inter-cell insulation layer is provided on the scribe line section. The counter conductive layer is connected with the conductive layer in the second region by extending to the second region by passing over the inter-cell insulation layer from the first region. The line width of the scribe line section is 60 $\mu$m or more, preferably 500 $\mu$m or less. Here, "the counter conductive layer extends to the second region by passing over the inter-cell insulation layer from the first region" includes not only a case where the counter conductive layer extends to the second region by coming into contact with the upper surface of the inter-cell insulation layer from the first region, but also a case where the counter conductive layer extends to the second region by passing from the first region above the inter-cell insulation layer without coming into contact with the upper surface of the inter-cell insulation layer.

A width D1 ($\mu$m) of the inter-cell insulation layer preferably satisfies the relational expression of $D1>D2+100$ $\mu$m using the line width D2 ($\mu$m) of the scribe line section.

The carrier transporting material is preferably an electrolytic solution.

The porous insulation layer is preferably in contact with the inter-cell insulation layer rather than the scribe line section. In addition, the pore diameter of the porous insulation layer is preferably 50 $\mu$m or more.

The inter-cell insulation layer preferably includes at least a silicon oxide. In addition, the pore diameter of the inter-cell insulation layer is preferably 100 nm or less.

A photoelectric conversion module of the present invention is provided with the photoelectric conversion element of the present invention. The photoelectric conversion layer which includes the porous semiconductor layer, the porous insulation layer, and the counter conductive layer are provided in sequence on the conductive layer in the second region. An insulation member which prevents movement of the carrier transporting material is provided between the photoelectric conversion layer, the porous insulation layer, and the counter conductive layer which are provided on the conductive layer in the first region, and the photoelectric conversion layer, the porous insulation layer, and the counter conductive layer which are provided on the conductive layer in the second region.

The inter-cell insulation layer preferably configures a part of the insulation member.

Advantageous Effects of Invention

In the photoelectric conversion element according to the present invention, since an increase in reverse current is suppressed, the photoelectric conversion efficiency is improved.

Brief Description of Drawings

[Fig. 1] Fig. 1 is a schematic cross-sectional diagram of a photoelectric conversion element according to one embodiment of the present invention.

[Fig. 2] Fig. 2 is a schematic cross-sectional diagram of a photoelectric conversion module according to one embodiment of the present invention.

[Fig. 3] Fig. 3 is a graph which shows results from investigating a relationship between a line width D2 of a scribe line section and a holding ratio (%) of photoelectric conversion efficiency of a photoelectric conversion element with respect to a sandwich cell.

[Fig. 4] Fig. 4 is a graph which shows results from investigating a relationship between the line width D2 of a scribe line section and a holding ratio (%) of photoelectric conversion efficiency of a photoelectric conversion module with respect to a sandwich cell.

Description of Embodiments

Below, description will be given of a photoelectric conversion element and a photoelectric conversion module of the present invention with reference to the drawings. Here, in the diagrams of the present invention, the same reference numerals represent the same portions or equivalent portions. In addition, the dimensional relationships such as the length, the width, the thickness, and the depth are appropriately changed for clarification and simplification of the diagrams and do not represent the actual dimensional relationships.

<Configuration of Photoelectric Conversion Element>

Fig. 1 is a schematic cross-sectional diagram of a photoelectric conversion element 10 according to the present invention. In the photoelectric conversion element 10 shown in Fig. 1, a conductive layer 2 is provided on a support material 1 and a photoelectric conversion layer 4, a porous insulation layer 5, a counter conductive layer 6, and a carrier transporting layer are provided in sequence on the conductive layer 2. The photoelectric conversion layer 4 includes a porous semiconductor layer and respective interval portions in the porous semiconductor layer, the porous insulation layer 5, and the counter conductive layer 6 are filled with a carrier transporting material.

A first region where the photoelectric conversion layer 4 is provided on the conductive layer 2 and a second region where the photoelectric conversion layer 4 is not provided on the conductive layer 2 are present in the photoelectric conversion element 10 shown in Fig. 1 and the first region and the second region interpose a scribe line section 3. The scribe line section 3 is configured without the conductive layer 2 being provided on the support material 1. An inter-cell insulation layer 9 is provided on the scribe line section 3.

The counter conductive layer 6 extends from the first region to the second region by passing over the inter-cell insulation layer 9 and is electrically connected with the conductive layer 2 in the second region. Thus, it is possible to manufacture a photoelectric conversion module 20 which will be described below when the photoelectric conversion layer 4, the porous insulation layer 5, the counter conductive layer 6, and the carrier transporting layer are formed in sequence on the conductive layer 2 in the second region.

In order to form the counter conductive layer 6 as described above, it is preferable to provide the inter-cell insulation layer 9 on the scribe line section 3 without passing through the photoelectric conversion layer 4 and the porous insulation layer 5 and it is more preferable to provide the counter conductive layer 6 on the inter-cell insulation layer 9. When the photoelectric conversion layer and the porous insulation layer are formed on the scribe line section, it is necessary to increase the line width of the scribe line section and, thus, there are times when this may lead to the photoelectric conversion element being lengthened in the width direction.

In the photoelectric conversion element 10 shown in Fig. 1, the line width D2 of the scribe line section 3 is 60 μm or more. Normally, it is preferable that the scribe line section be formed by a single step from the point of view of production tact. Also in other solar cells (for example, a silicon thin-film solar cell, a CIGS solar cell, or the like) which have a glass plate with an attached transparent conductive layer, the scribe line section is formed by a single step or several scribe line sections are formed in parallel by being spaced at intervals in order to suppress a decrease in yield due to short circuits. Due to this, it is possible to sufficiently suppress normal short circuits. Here, the line width of a scribe line section of the prior art is approximately 50 μm.

However, when a monolithic type photoelectric conversion element (a photoelectric conversion module according to the present invention) is manufactured by connecting two or more photoelectric conversion elements, where the line width of the scribe line section is approximately 50 μm, in series on one substrate and a heat resistance test (application of heat stress), for example, at 85°C is performed with respect to the obtained monolithic type photoelectric conversion element, the photoelectric conversion efficiency of the monolithic type photoelectric conversion element remarkably decreases even in a case where a plurality of scribe line sections are formed in parallel by being spaced at intervals. The cause of this is not known; however, it may be considered that an increase in the reverse current between the regions which are divided by the scribe line section is the cause.

Thus, in the present invention, the line width D2 of the scribe line section 3 is 60 μm or more and the inter-cell insulation layer 9 is provided on the scribe line section 3. Due to this, it is possible to suppress an increase in the reverse current between the regions which are divided by the scribe line section 3 and to achieve an improvement in the decrease

in the photoelectric conversion efficiency with respect to external environmental factors such as heat. Thus, it is possible to prevent changes in the photoelectric conversion efficiency with respect to the passage of time.

In addition, the inter-cell insulation layer 9 is provided on the scribe line section 3. Therefore, when the line width D2 of the scribe line section 3 is 60 μm or more, it is possible to suppress an increase in the reverse current which flows between the regions which are divided by the scribe line section 3 when external environmental factors such as heat act as a load (may be referred to below as "during heat loading"). Thus, it is possible to achieve an improvement in the photoelectric conversion efficiency with respect to external environmental factors such as heat without a large decrease in the light receiving area on an upper surface of the support material 1. Below, each of the configurations of the photoelectric conversion element 10 will be described.

<Support Material>

The material which configures the support material 1 is not particularly limited as long as the material is able to be generally used for a support material of a photoelectric conversion element and is able to exhibit the effects of the present invention. However, it is preferable that the support material 1 be formed of a material with a light transmitting property since a light transmitting property is necessary in the portion which is a light receiving surface of the photoelectric conversion element 10. For example, the support material 1 may be a glass substrate such as soda-lime glass, fused quartz glass, or crystalline quartz glass, or may be a heat resistant resin plate such as a flexible film. However, even in a case of being used as a light receiving surface, it is sufficient if the support material 1 substantially transmits light with a wavelength to which at least a coloring dye has an effective sensitivity, which will be described below (the light transmittance is, for example, 80% or more, preferably 90% or more), the support material 1 does not necessarily need to have a transmitting property with respect to light of all wavelengths.

Examples of the material which configures the flexible film (also referred to below as "film") include tetraacetylcellulose (TAC), polyethylene terephthalate (PET), polyphenylene sulfide (PPS), polycarbonate (PC), polyarylate (PA), polyetherimide (PEI), a phenoxy resin, polytetrafluoroethylene (PTFE), or the like.

In a case of forming another layer on the support material 1 by heating, for example, in a case of forming a porous semiconductor layer on the support material 1 by heating at approximately 250°C, it is particularly preferable to use polytetrafluoroethylene, which has heat resistance to 250°C or more, out of the materials which configure the film described above.

It is possible to use the support material 1 when the photoelectric conversion element 10 which is completed is attached to another structural body. That is, it is possible to easily attach a peripheral section of the support material 1 such as a glass substrate to another support material using a metal processed component and a screw.

The thickness of the support material 1 is not particularly limited; however, approximately 0.2 mm to 5 mm is preferable in consideration of the light transmitting property or the like.

<Conductive Layer>

The material which configures the conductive layer 2 is not particularly limited as long as the material is able to be generally used for a conductive layer of a photoelectric conversion element and is able to exhibit the effects of the present invention. However, since the conductive layer 2 is a light receiving surface of the photoelectric conversion element 10, a light transmitting property is necessary and thus, it is preferable that the conductive layer 2 be formed of a material with a light transmitting property. For example, it is sufficient if the conductive layer 2 is Indium Tin Oxide (ITO), tin oxide doped with fluorine (FTO), zinc oxide (ZnO), or the like. However, in the same manner as the support material 1, it is sufficient if the conductive layer 2 substantially transmits light with a wavelength to which at least a coloring dye has an effective sensitivity, which will be described below (the light transmittance is, for example, 80% or more, preferably 90% or more), the conductive layer 2 does not necessarily need to have a transmitting property with respect to light of all wavelengths.

The film thickness of the conductive layer 2 is not particularly limited; however, approximately 0.02 to 5 μm is preferable. It is preferable that the film resistance of the conductive layer 2 be as low as possible and 40 Ω/sq or less is preferable.

A metal lead line may be provided in the conductive layer 2 in order to lower the resistance. Examples of the material of the metal lead line include platinum, gold, silver, copper, aluminum, nickel, titanium, or the like. The thickness of the metal lead line is not particularly limited; however, when the metal lead line is excessively thick, there is a concern that this will lead to a decrease in the amount of incident light from the light receiving surface. Therefore, it is preferable that the thickness of the metal lead line be approximately 0.1 to 4 mm.

In the present invention, there are times when a structural body where the conductive layer 2 is laminated on the support material 1 is referred to as a transparent electrode substrate 11. Examples of the transparent electrode substrate 11 include a transparent electrode substrate where the conductive layer 2 formed of FTO is laminated on the

support material 1 formed of soda-lime float glass and the transparent electrode substrate 11 is favorably used in the present invention.

<Scribe Line Section>

The line width D2 of the scribe line section 3 is 60 μm or more, preferably 100 (μm or more, and more preferably 200 μm or more. Since it is possible to further suppress an increase in the reverse current between the regions which are divided by the scribe line section 3 as the line width D2 of the scribe line section 3 increases, the photoelectric conversion efficiency is improved with respect to external environmental factors such as heat. However, it is preferable that the line width D2 of the scribe line section 3 be 500 μm or less. This is because, when the line width D2 of the scribe line section 3 is over 500 μm, since this leads to a reduction of the photoelectric conversion layer 4 or the like, this may cause a decrease in photoelectric conversion efficiency.

In a case where a part of the scribe line section 3 (preferably the entire scribe line section 3) is in contact with an electrolytic solution held by the porous insulation layer 5 or the like, the effects of the present invention are particularly remarkable. Here, the electrolytic solution is one example of a carrier transporting material which will be described below and the composition and the like are as described below.

The method for forming the scribe line section 3 is not particularly limited. For example, the portion, which becomes the scribe line section 3, may be removed from the conductive layer by a laser scribe method or the like after the conductive layer is formed on the entirety of the upper surface of the support material 1. Alternatively, after providing a mask or the like on a portion which is the scribe line section 3 on the upper surface of the support material 1 and then forming the conductive layer 2 in a portion where the mask or the like is not provided on the upper surface of the support material 1, the mask may be removed.

<Photoelectric Conversion Layer>

The photoelectric conversion layer 4 is configured by a coloring dye, quantum dots, or the like being adsorbed on a porous semiconductor layer and the porous semiconductor layer being filled with a carrier transporting material.

-Porous Semiconductor Layer-

Examples of the form of the porous semiconductor layer include a bulk form, a layer which includes a particulate semiconductor material, a film form where a large number of micropores are formed, and the like; however, a film form where a large number of micropores are formed is preferable. Due to this, it is possible to sufficiently ensure the adsorption amount of the coloring dye, the amount of the carrier transporting material, and the like.

"Porous" in the porous semiconductor layer has the meaning that the porosity is 20% or more and that the specific surface area is 0.5 to 300 $m^2/g$. From the point of view of sufficiently ensuring the adsorption amount of the coloring dye or the like, it is preferable that the specific surface area of the porous semiconductor layer be approximately 10 to 200 $m^2/g$. Here, the porosity of the porous semiconductor layer is determined by calculation from the thickness (the film thickness) of the porous semiconductor layer, the mass of the porous semiconductor layer, and the concentration of semiconductor fine particles. The specific surface area of the porous semiconductor layer is determined using the BET method which is a gas adsorption method.

The semiconductor material which configures the porous semiconductor layer is not particularly limited as long as the semiconductor material is generally used for a photoelectric conversion material. Examples of such a material include compounds such as titanium oxide, zinc oxide, tin oxide, iron oxide, niobium oxide, cerium oxide, tungsten oxide, nickel oxide, strontium titanate, cadmium sulfide, lead sulfide, zinc sulfide, indium phosphide, copper-indium sulfide ($CuInS_2$), $CuAlO_2$, or $SrCu_2O_2$. These compounds may be used individually or may be used in combination. Among these compounds, it is preferable to use titanium oxide, zinc oxide, tin oxide, or niobium oxide. In terms of photoelectric conversion efficiency, stability, and safety, it is preferable to use titanium oxide.

In the present invention, in a case of using titanium oxide as the material which configures the porous semiconductor layer, the titanium oxide may be various types of titanium oxide in the strict sense such as anatase type titanium oxide, rutile type titanium oxide, amorphous titanium oxide, metatitanic acid, orthotitanic acid, or the like, may be titanium hydroxide, or may be hydrous titanium oxide. These may be used individually or may be used in a mixture. It is possible for the titanium oxide to take the form of either of anatase type titanium oxide or rutile type titanium oxide according to the manufacturing method and thermal history thereof; however, anatase type titanium oxide is typical.

The average particle diameter of the semiconductor material is not particularly limited, but is preferably appropriately set in consideration of the fact that it is possible to adjust the light scattering property of the photoelectric conversion layer 4 according to the average particle diameter of the semiconductor material. In detail, although it depends on the forming conditions or the like of the photoelectric conversion layer 4, the photoelectric conversion layer 4 contributes

to an improvement in the light capture ratio by scattering incident light in a case where the photoelectric conversion layer 4 includes a porous semiconductor layer which is formed of a semiconductor material where the average particle diameter is large. On the other hand, the photoelectric conversion layer 4 contributes to an increase in the adsorption amount of the coloring dye by increasing the adsorption points of the coloring dye since the light scattering is not excellent in a case where the photoelectric conversion layer 4 includes a porous semiconductor layer formed of a semiconductor material with a small average particle diameter. The porous semiconductor layer may be a single layer formed of a semiconductor material where the average particle diameter is substantially the same; however, the porous semiconductor layer may be configured by laminating a layer formed of a semiconductor material where the average particle diameter is comparatively small and a layer formed of a semiconductor material where the average particle diameter is comparatively large. A semiconductor material where the average particle diameter is comparatively small preferably has an average particle diameter of 5 nm or more to less than 50 nm and more preferably has an average particle diameter of 10 nm or more to 30 nm or less. Due to this, since it is possible to obtain an effective surface area which is sufficiently large with respect to a projected area, it is also possible to obtain an effect where it is possible to convert the incident light into electrical energy with a high yield. A semiconductor material where the average particle diameter is comparatively large preferably has an average particle diameter of 50 nm or more, more preferably has an average particle diameter of 50 nm or more to 600 nm or less, and even more preferably has an average particle diameter of 50 nm or more to 100 nm or less. Here, in the point that the incident light is effectively used for the photoelectric conversion, it is preferable that an average particle diameter of a semiconductor material be approximately uniform as in commercially available semiconductor materials.

From the above, from the point of view of improving the light scattering, the semiconductor material is preferably titanium oxide where the average particle diameter is 50 nm or more and more preferably titanium oxide where the average particle diameter is 50 nm or more to 100 nm or less.

Here, in the present specification, the average particle diameter is a value which is determined from diffraction peaks of XRD (X-ray diffraction). In detail, the average particle diameter is determined from the half value width of the diffraction angle in XRD $\theta/2\theta$ measurement and the Scherrer equation. For example, in a case where the semiconductor material is anatase type titanium oxide, it is sufficient if the half value width of the diffraction peak ($2\theta$=25.3° or the vicinity) which corresponds to a (101) surface is measured.

The film thickness of the photoelectric conversion layer 4 is not particularly limited; however, approximately 0.5 to 50 μm is preferable from the point of view of photoelectric conversion efficiency. In particular, in a case where the photoelectric conversion layer 4 is provided with a porous semiconductor layer formed of a semiconductor material where the average particle diameter is 50 nm or more, the photoelectric conversion layer 4 preferably has a film thickness of 0.1 to 40 μm and more preferably has a film thickness of 5 to 20 μm. In a case where the photoelectric conversion layer 4 is provided with a porous semiconductor layer formed of a semiconductor material where the average particle diameter is 5 nm or more to less than 50 nm, the photoelectric conversion layer 4 preferably has a film thickness of 0.1 to 50 μm and more preferably has a film thickness of 10 to 40 μm.

In general, an insulation layer is provided between the photoelectric conversion layer formed of a porous semiconductor layer and the counter conductive layer. However, for example, as disclosed in Japanese Unexamined Patent Application Publication No. 2007-194039, a counter conductive layer or a conductive layer (a single layer) may be formed on a photoelectric conversion layer which includes a porous semiconductor layer formed of a semiconductor material with a large average particle diameter (the average particle diameter is approximately 100 nm to 500 nm). However, when the average particle diameter of the semiconductor material which configures the portion which comes into contact with the counter conductive layer out of the photoelectric conversion layer is large, this leads to a decrease in the mechanical strength of the photoelectric conversion layer and thus, there are cases where problems occur with the structure of the photoelectric conversion element. In such a case, the mechanical strength of the photoelectric conversion layer may be strengthened by blending a semiconductor material where the average particle diameter is small with a semiconductor material where the average particle diameter is large, for example, by blending a semiconductor material where the average particle diameter is small at a ratio of 10% by mass or less of the entire material.

-Photosensitizing Agent-

Examples of a coloring dye which functions as a photosensitizing agent by being adsorbed on the porous semiconductor layer include an organic coloring dye, a metal complex coloring dye, or the like, which have absorption in at least one region out of the visible light region and the infrared light region. These coloring dyes may be used individually or may be used in a mixture of two or more types.

The organic coloring dye is, for example, an azo-based coloring dye, a quinone-based coloring dye, a quinoneimine-based coloring dye, a quinacridone-based coloring dye, a squarylium-based coloring dye, a cyanine-based coloring dye, a merocyanine-based coloring dye, a triphenylmethane-based coloring dye, a xanthene-based coloring dye, a porphyrin-based coloring dye, a perylene-based coloring dye, an indigo-based coloring dye, a phthalocyanine-based

coloring dye, a naphthalocyanine-based coloring dye, or the like. The absorption coefficient of an organic coloring dye is generally larger than the absorption coefficient of a metal complex coloring dye.

A metal complex coloring dye is configured by molecules (ligands) being coordinated with a transition metal. The transition metal is, for example, Cu, Ni, Fe, Co, V, Sn, Si, Ti, Ge, Cr, Zn, Ru, Mg, Al, Pb, Mn, In, Mo, Y, Zr, Nb, Sb, La, W, Pt, Ta, Ir, Pd, Os, Ga, Tb, Eu, Rb, Bi, Se, As, Sc, Ag, Cd, Hf, Re, Au, Ac, Tc, Te, Rh, or the like. Examples of the metal complex coloring dye include a phthalocyanine-based metal complex coloring dye or a ruthenium-based metal complex coloring dye, the ruthenium-based metal complex coloring dye is preferable, and the ruthenium-based metal complex coloring dye which is represented by the following chemical formulas (1) to (3) is more preferable.

[Chem. 1]

Chemical formula (1)

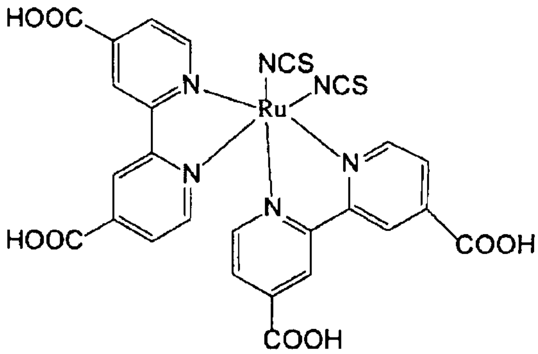

[Chem. 2]

Chemical formula (2)

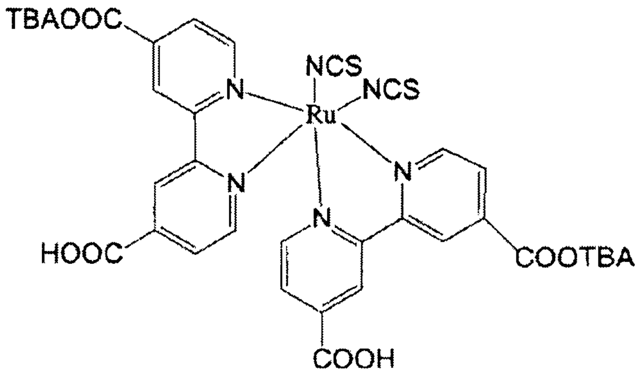

[Chem. 3]

Chemical formula (3)

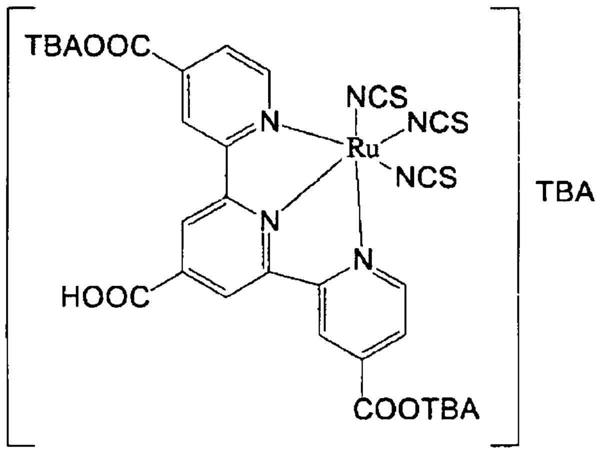

In order to firmly adsorb the coloring dye on the porous semiconductor layer, the coloring dye preferably has an interlocking group such as a carboxylic acid group, a carboxylic acid anhydrous group, an alkoxy group, a hydroxyl group, a hydroxyalkyl group, a sulfonate group, an ester group, a mercapto group, or a phosphonyl group in the molecule and more preferably has a carboxylic acid group or a carboxylic acid anhydrous group. Here, the interlocking group provides an electrical bond which facilitates the movement of electrons between the excited state of a coloring dye and the conduction band of a semiconductor material.

Examples of a quantum dot which functions as a photosensitizing agent by being adsorbed on the porous semiconductor layer include CdS, CdSe, PbS, PbSe, or the like.

The adsorption amount of the photosensitizing agent is preferably $1\times10^{-8}$ mol/cm$^2$ or more to $1\times10^{-6}$ mol/cm$^2$ or less, and more preferably $5\times10^{-8}$ mol/cm$^2$ or more to $5\times10^{-7}$ mol/cm$^2$ or less. When the adsorption amount of the photosensitizing agent is less than $1\times10^{-8}$ mol/cm$^2$, there is a concern that this will lead to a decrease in the photoelectric conversion efficiency. On the other hand, when the adsorption amount of the photosensitizing agent exceeds $1\times10^{-6}$ mol/cm$^2$, there are times when this leads to an issue in that the opening voltage is reduced.

Representative examples of a method for adsorbing the photosensitizing agent on the porous semiconductor layer include a method for immersing the porous semiconductor layer in a solution where the coloring dye is dissolved (a solution for adsorbing a coloring dye). At this time, from the point of view of the solution for adsorbing a coloring dye permeating up to the inner parts of the fine pores in the porous semiconductor layer, it is preferable to heat the solution for adsorbing the coloring dye.

The carrier transporting material which is used to fill the porous semiconductor layer is as described in <Carrier Transporting Layer> which will be described below.

<Porous Insulation Layer>

In the photoelectric conversion element, in general, the porous insulation layer 5 is provided between the photoelectric conversion layer 4 and the counter conductive layer 6. Here, "porous" in the porous insulation layer 5 has the meaning that the porosity is 20% or more and that the specific surface area is 10 to 100 m$^2$/g. The pore diameter of the porous insulation layer 5 is preferably 50 μm or more, and more preferably 50 μm or more to 200 μm or less. In other words, the porous insulation layer 5 is preferably formed of particles where the average particle diameter is 5 to 500 nm and is more preferably formed of particles where the average particle diameter is 10 to 300 nm. Due to this, it is possible for the porous insulation layer 5 to hold the carrier transporting material. Here, it is preferable that the pore diameter of the porous insulation layer 5 be measured, for example, by the BET method. It is preferable that each of the methods for measuring the porosity of the porous insulation layer 5 and the average particle diameter of particles which configure the porous insulation layer 5 be the methods which are described in <Photoelectric Conversion Layer> described above.

The material of the porous insulation layer 5 is not particularly limited, but may be glass or may be an insulation material with a high conduction band level such as zirconium oxide, silicon oxide, aluminum oxide, niobium oxide, strontium titanate, or the like. It is preferable that the porous insulation layer 5 include zirconium oxide, or titanium oxide

where the average particle diameter is 100 nm or more.

The film thickness of the porous insulation layer 5 is not particularly limited; however, from the point of view of the insulation property, 2 μm or more to 50 μm or less is preferable, and 5 μm or more to 20 μm or less is more preferable.

It is preferable that the porous insulation layer 5 be in contact with the inter-cell insulation layer 9 as shown in Fig. 1 and not the scribe line section 3. Due to this, it is possible to suppress an increase in the reverse current which flows between the conductive layer 2 in the first region and the conductive layer 2 in the second region via the scribe line section 3 when external environmental factors such as heat act as a load.

<Counter Conductive Layer>

In the present invention, the combination of a catalyst layer, which has a catalytic activity and a function of restoring positive holes in the carrier transporting layer, and a conductive layer, which collects electrons and makes it possible to connect adjacent photoelectric conversion elements in series, is referred to as the counter conductive layer 6. Therefore, the counter conductive layer 6 may be configured by laminating the catalyst layer and the conductive layer, may be a catalyst layer (a single layer) which has high conductivity, or may be a conductive layer (a single layer) which has a catalytic function. In addition, an aspect where a catalyst layer is further provided to be separate from the counter conductive layer 6 is also included in the present invention.

In a case where the counter conductive layer 6 has a laminated structure of a catalyst layer and a conductive layer, the catalyst layer is usually formed on the porous insulation layer 5 and the conductive layer is formed on the catalyst layer. However, in a case where the film strength of the catalyst layer which is formed is not very strong such as in a case where the catalyst layer (a platinum layer or the like) is formed by a vapor deposition method, when the conductive layer is formed on the catalyst layer which is formed on the porous insulation layer, there are times when the conductive layer peels off from the catalyst layer. In this case, it is preferable that the conductive layer be provided on the porous insulation layer 5 and that the catalyst layer be provided on the conductive layer.

The material which configures the conductive layer of the counter conductive layer 6 is not particularly limited, but it is preferable that the material be able to be generally used for the conductive layer of the photoelectric conversion element and able to exhibit the effects of the present invention. The material of the conductive layer may be, for example, a metallic oxide such as composite oxide of indium and tin (ITO), tin oxide doped with fluorine (FTO), or zinc oxide (ZnO) or may be a metal material such as titanium, tungsten, gold, silver, copper, or nickel. In consideration of the film strength of the conductive layer, the material which configures the conductive layer is ideally titanium.

When the conductive layer of the counter conductive layer 6 is formed by a vapor deposition method, since the conductive layer itself is porous, it is not necessary to separately form holes in the conductive layer in order to move the coloring dye solution, the carrier transporting material, or the like. In a case of forming the conductive layer of the counter conductive layer 6 by a vapor deposition method, the hole diameter of the holes which are naturally formed in the conductive layer is approximately 1 nm to 20 nm. Even when the catalyst layer is formed on the conductive layer, it was confirmed that there is no concern that the material which configures the catalyst layer will reach the porous insulation layer 5 and then the porous semiconductor layer (the photoelectric conversion layer 4) by passing through the inside of the holes which are formed in the conductive layer.

On the other hand, in a case of forming the catalyst layer of the counter conductive layer 6 by a coating method using a fine particulate dispersion paste formed of platinum or carbon, there is a concern that the fine particles which configure the catalyst layer will pass through the conductive layer of the counter conductive layer 6. In this case, it is preferable that the conductive layer of the counter conductive layer 6 be a dense layer and it is sufficient if holes are formed at the same time in the conductive layer of the counter conductive layer 6 and the catalyst layer of the counter conductive layer 6 after forming the catalyst layer of the counter conductive layer 6. In such a case, the material of the conductive layer of the counter conductive layer 6 may be, for example, a metallic oxide such as a composite oxide of indium and tin (ITO), tin oxide doped with fluorine (FTO), or zinc oxide (ZnO) or may be a metal material such as titanium, tungsten, gold, silver, copper, or nickel.

In a case of intentionally forming holes on the counter conductive layer 6, it is preferable to partially evaporate the counter conductive layer 6, for example, by irradiation of laser light. The diameter of such holes is preferably 0.1 μm to 100 μm, and more preferably 1 μm to 100 μm. In addition, the intervals between the holes are preferably 1 μm to 200 μm, and more preferably 5 μm to 200 μm.

The film thickness of the counter conductive layer 6 is not particularly limited. However, the resistance of the counter conductive layer 6 is high when the film thickness of the counter conductive layer 6 is excessively thin and the movement of the carrier transporting material is interrupted when the film thickness of the counter conductive layer 6 is excessively thick. It is preferable to appropriately select the film thickness of the counter conductive layer 6 in consideration of the above and the film thickness of the counter conductive layer 6 is preferably approximately 50 nm to 5 μm.

The material which configures the catalyst layer of the counter conductive layer 6 is not particularly limited as long as the material is able to be generally used for the catalyst layer of a photoelectric conversion element and is able

to exhibit the effects of the present invention. As such a material, for example, platinum or carbon is preferable. As the form of the carbon, carbon black, graphite, glass carbon, amorphous carbon, hard carbon, soft carbon, carbon whiskers, carbon nanotubes, fullerene, or the like is preferable.

Here, as necessary, an extraction electrode (which is not shown in the diagram) is provided on the counter conductive layer 6. It is possible to extract current from the photoelectric conversion element to the outside using the extraction electrode. The material of the extraction electrode is not particularly limited as long as the material is able to be generally used for the photoelectric conversion elements and is able to exhibit the effects of the present invention.

<Covering Layer>

A covering layer 7 is provided with an object of preventing volatilization of the electrolytic solution and preventing permeation of water or the like to the inside of the cell. The material which configures the covering layer 7 is not particularly limited as long as the material is able to be generally used for a covering layer of a photoelectric conversion element and is able to exhibit the effects of the present invention. Examples of such a material include soda-lime glass, lead glass, borosilicate glass, fused quartz glass, crystalline quartz glass, or the like and the material is preferably soda-lime glass.

<Insulation Member>

An insulation member 8 is provided with an object of preventing volatilization of the electrolytic solution, preventing permeation of water or the like to the inside of a cell, absorbing impacts (stress) of falling objects which act on the support material 1, absorbing bending or the like which acts on the support material 1 during usage over a long period, and the like. In addition to this, the insulation member 8 is able to prevent the carrier transporting material (for example, an electrolytic solution) from moving back and forth between adjacent photoelectric conversion elements when the photoelectric conversion module 20 which will be described below is manufactured using the photoelectric conversion element 10 shown in Fig. 1. Here, an element which is configured by the conductive layer 2, the photoelectric conversion layer 4, the porous insulation layer 5, the counter conductive layer 6, and the carrier transporting layer, which are provided in sequence on a support material 21 (refer to Fig. 2) is included in the photoelectric conversion element as a constituent element of the photoelectric conversion module 20.

The material which configures the insulation member 8 is not particularly limited as long as the material is able to be generally used for an insulation member of the photoelectric conversion element and is able to exhibit the effects of the present invention. Such a material may be, for example, a silicone resin, an epoxy resin, or a polyisobutylene-based resin, may be a hot melt resin such as a polyamide-based resin, a polyolefin-based resin, or an ionomer resin, or may be a glass frit. In a case where the insulation member 8 is configured using two or more types of these materials, two or more types of materials may be mixed, or layers formed of each of the materials may be laminated. In a case of using a nitrile-based solvent or carbonate-based solvent as a solvent of an electrolyte with redox properties, it is preferable that the material which configures the insulation member 8 be a silicone resin, a hot melt resin, a polyisobutylene-based resin, or a glass frit.

<Inter-cell Insulation Layer>

The inter-cell insulation layer 9 is provided on the scribe line section 3. The material which configures the inter-cell insulation layer 9 is preferably at least one of, for example, silicon oxide, aluminum oxide, magnesium oxide, and the like and more preferably silicon oxide.

It is preferable that the inter-cell insulation layer 9 be a layer which is denser than the porous insulation layer 5. Due to this, since it is possible to prevent the carrier transporting material from permeating the inter-cell insulation layer 9 from the porous insulation layer 5, it is possible to maintain a high insulation property in the inter-cell insulation layer 9 and a high insulation property in the conductive layer 2 in the first region and the conductive layer 2 of the second region. Thus, since an increase in the reverse current between the regions which are divided by the scribe line section 3 is further suppressed, the photoelectric conversion efficiency is further improved with respect to external environmental factors such as heat. Accordingly, it is possible to further prevent changes in the photoelectric conversion efficiency with respect to the passage of time.

The inter-cell insulation layer 9 being a dense layer has the meaning that the porosity is 50% or less and that the specific surface area is 50 $m^2/g$ or less. The pore diameter of the inter-cell insulation layer 9 is preferably 100 nm or less and more preferably 5 nm or more to 50 nm or less. In other words, it is preferable for the inter-cell insulation layer 9 to be formed of a particles where the average particle diameter is 5 to 50 nm, and preferably formed of particles where the average particle diameter is 5 to 30 nm. Here, it is preferable that each of the methods for measuring the porosity of the inter-cell insulation layer 9, the specific surface area of the inter-cell insulation layer 9, and the average

particle diameter of the particles which configure the inter-cell insulation layer 9 be the methods which are described in <Photoelectric Conversion Layer> described above. In addition, it is preferable that the pore diameter of the inter-cell insulation layer 9 be measured by the same method as the method for measuring the pore diameter of the porous insulation layer 5.

Since the inter-cell insulation layer 9 is a dense layer, it is possible to ensure the strength of the inter-cell insulation layer 9. Thus, as shown in Fig. 1, it is possible to provide the insulation member 8 on the inter-cell insulation layer 9 to interpose the counter conductive layer 6. In other words, it is possible to configure a part of the insulation member 8 with the inter-cell insulation layer 9. Due to this, it is possible to reduce the size of the photoelectric conversion element 10 and this contributes to an improvement in the ratio of active area to aperture area of the photoelectric conversion element in the photoelectric conversion module 20 shown in Fig. 2.

The size of the inter-cell insulation layer 9 is not particularly limited; however, it is preferable that the width D1 ($\mu$m) of the inter-cell insulation layer 9 satisfy the following formula (1). Due to this, since an increase in the reverse current between the regions which are divided by the scribe line section 3 is further suppressed, the photoelectric conversion efficiency is further improved with respect to external environmental factors such as heat. Accordingly, it is possible to further prevent changes in the photoelectric conversion efficiency with respect to the passage of time.

$$D1>D2+100\ \mu m: \text{Formula (1)}$$

It is more preferable that the width D1 ($\mu$m) of the inter-cell insulation layer 9 satisfy the following formula (2). Due to this, it is possible to prevent the photoelectric conversion element 10 from increasing in size (a decrease in the ratio of active area to aperture area) as a result of providing the inter-cell insulation layer 9.

$$D2+300\ \mu m>D1>D2+100\ \mu m: \text{Formula (2)}$$

<Carrier Transporting Layer>

In the present invention, the "carrier transporting layer" is positioned inside the insulation member 8 and is configured by the carrier transporting material being introduced into a region which is interposed between the conductive layer 2 and the covering layer 7. Accordingly, at least the photoelectric conversion layer 4 and the porous insulation layer 5 are also filled with the carrier transporting material.

The carrier transporting material is preferably a conductive material which is able to transport ions and is preferably, for example, a liquid electrolyte, a solid electrolyte, a gel electrolyte, a molten salt gel electrolyte, or the like.

The liquid electrolyte is preferably a liquid which includes a redox species and is not particularly limited as long as it is possible for the liquid electrolyte to be used in typical cells, solar cells, and the like. In detail, it is preferable that the liquid electrolyte be a liquid electrolyte formed of a redox species and a solvent which is able to dissolve the redox species, a liquid electrolyte formed of a redox species and a molten salt which is able to dissolve the redox species, or a liquid electrolyte formed of a redox species and the solvent and the molten salt.

Examples of the redox species include $I^-/I^{3-}$-based redox species, $Br^{2-}/Br^{3-}$-based redox species, $Fe^{2+}/Fe^{3+}$ based redox species, quinone/hydroquinone based redox species, and the like. In detail, the redox species may be a combination of metal iodides, such as lithium iodide (LiI), sodium iodide (NaI), potassium iodide (KI), or calcium iodide ($CaI_2$), and iodine ($I_2$). The redox species may be a combination of tetraalkylammonium salt, such as tetraethylammonium iodide (TEAI), tetrapropylammonium iodide (TPAI), tetrabutylammonium iodide (TBAI), or tetrahexylammonium iodide (THAI), and iodine. The redox species may be a combination of metal bromide, such as lithium bromide (LiBr), sodium bromide (NaBr), potassium bromide (KBr), or calcium bromide ($CaBr_2$), and bromine. Out of these, the combination of LiI and $I_2$ is particularly preferable.

Examples of solvents which are able to dissolve the redox species include carbonate compounds such as propylene carbonate, nitryl compounds such as acetonitrile, alcohols such as ethanol, water, or aprotic polar substances. Out of these, the carbonate compound and the nitryl compound are particularly preferable. It is possible to use these solvents in a mixture of two or more types.

It is preferable that the solid electrolytes be a conductive material which is able to transport electrons, holes, or ions, be able to be used as an electrolyte of the photoelectric conversion element, and not have fluidity. In detail, examples of the solid electrolytes include a hole transporting material such as polycarbazole, an electron transporting material such as tetranitrofluorolenon, a conductive polymer such as polyroll, polyelectrolytes where a liquid electrolyte is solidified by a polymer compound, p-type semiconductors such as copper iodide or cuprous thiocyanate, electrolytes where a liquid electrolyte which includes molten salt is solidified by fine particles, or the like.

The gel electrolyte is usually formed of an electrolyte and a gelling agent. The electrolyte may be, for example, the liquid electrolytes described above or may be the solid electrolytes described above.

Examples of the gelling agent include polymer gelling agent such as cross-linked polyacrylic acid resin derivatives, cross-linked polyacrylonitrile derivatives, polyalkylene oxide derivatives, silicone resins, and polymers which have a nitrogen-containing heterocycle quaternary compound salt structure in the side chain.

The molten salt gel electrolytes are usually formed of the gel electrolytes as described above and normal temperature molten salts.

Examples of normal temperature molten salts include nitrogen containing heterocycle quaternary ammonium salts such as pyridinium salts or imidazolium salts and the like.

It is preferable that the electrolytes described above include additives, which will be described below, as necessary. The additives may be nitrogen containing aromatic compounds such as t-butylpyridine (TBP), or may be imidazole salts such as dimethyl propyl imidazole iodide (DMPII), methyl propyl imidazole iodide (MPII), ethyl methyl imidazole iodide (EMII), ethyl imidazole iodide (EII), or hexyl methyl imidazole iodide (HMII).

The concentration of the electrolytes is preferably within the range of 0.001 to 1.5 mol/l, and particularly preferably within the range of 0.01 to 0.7 mol/l. However, in a case where there is a catalyst layer of the counter conductive layer 6 on the light receiving surface side in the photoelectric conversion element according to the present invention, the incident light passes through the electrolytic solution inside the carrier transporting layer and reaches the porous semiconductor layer (a coloring dye is adsorbed on the porous semiconductor layer), and the carriers are excited. Therefore, in the photoelectric conversion element with a catalyst layer on the light receiving surface side, there are times when the performance of the photoelectric conversion element depends on the concentration of the electrolytes. It is preferable to set the concentration of the electrolyte in consideration of this point.

<Method for Manufacturing Photoelectric Conversion Element>

Description will be given below of the method for manufacturing the photoelectric conversion element 10 shown in Fig. 1.

The conductive layer 2 is formed on the support material 1. Here, the method for forming the conductive layer 2 is not particularly limited, but it is preferably, for example, a sputtering method which is known in the art or a spraying method which is known in the art. In addition, in a case of providing a metal lead line (which is not shown in the diagram) on the conductive layer 2, for example, the conductive layer 2 may be formed on the support material 1 which includes the obtained metal lead line after forming the metal lead line on the support material 1 using a sputtering method which is known in the art, a vapor deposition method which is known in the art, or the like, or the metal lead line may be formed on the conductive layer 2 after forming the conductive layer 2 on the support material 1.

Next, the scribe line section 3 is formed by cutting a part of the conductive layer 2 using a laser scribe method. At this time, it is preferable to repeatedly perform the steps with respect to the conductive layer 2 until the line width D2 of the scribe line section 3 becomes a desired value (60 $\mu$m or more, preferably 100 $\mu$m or more to 500 $\mu$m or less, and more preferably 200 $\mu$m or more to 500 $\mu$m or less).

Subsequently, the porous semiconductor layer is formed on the conductive layer 2. The method for forming the porous semiconductor layer is not particularly limited and firing may be carried out after coating paste which contains a semiconductor material in particle form on the conductive layer 2 using a screen printing method or an ink jet method and a sol-gel method or an electrochemical redox reaction may be used instead of the firing. Out of these methods, a screen printing method in which paste is used is particularly preferable from the point of view that it is possible to form a porous semiconductor layer with a thick film at a low cost.

The method for forming the porous semiconductor layer in a case of using titanium oxide as a semiconductor material will be described below in detail.

Firstly, after dropping 125 ml of titanium isopropoxide (manufactured by Kishida Chemical Co., Ltd.) into 0.1 M of 750 ml of a nitric acid aqueous solution (manufactured by Kishida Chemical Co., Ltd.) and carrying out hydrolyzation, heating is carried out for 8 hours at 80°C. Due to this, a sol liquid is prepared. A colloidal solution which includes titanium oxide particles where the average particle diameter (the average primary particle diameter) is 15 nm is prepared by heating the obtained sol liquid at 230°C in an autoclave made of titanium for 11 hours, growing titanium oxide particles, and performing ultrasonic dispersion for thirty minutes. Ethanol which is twice the volume of the colloidal solution is added to the obtained colloidal solution and the resultant is centrifuged at a rotation speed of 5000 rpm. Due to this, titanium oxide particles are obtained.

Next, the obtained titanium oxide particles are cleaned. After that, the titanium oxide particles are mixed with ethyl cellulose and terpineol dissolved in dehydrated ethanol, and stirred. Due to this, titanium oxide particles are dispersed. After that, titanium oxide paste is obtained by heating the mixed liquid described above under conditions of a vacuum and evaporating the ethanol. As the final composition, each of the concentrations is adjusted such that, for example, the titanium oxide solid concentration is 20 wt%, the ethyl cellulose concentration is 10 wt%, and the terpineol

concentration is 64 wt%.

Here, other than the above, examples of solvents used for preparing titanium oxide paste include glime-based solvents such as ethylene glycol monoethyl ether, alcohol-based solvents such as isopropyl alcohol, mixed solvents such as isopropyl alcohol/toluene, water, or the like. It is also possible to use these solvents in cases of preparing a paste which includes semiconductor particles other than titanium oxide.

Next, firing is carried out after coating and drying titanium oxide paste on the conductive layer using the method described above. Due to this, a porous semiconductor layer formed of titanium oxide is obtained. Here, the drying conditions and the firing conditions, for example, conditions such as the temperature, the time, or the atmosphere are appropriately adjusted according to the material of the support material or the semiconductor material which is used. For example, it is preferable to perform the firing under an air atmosphere or under an inert gas atmosphere within a range of approximately 50 to 800°C for approximately 10 seconds to 12 hours. In addition, the drying and firing may each be performed once at the same temperature or may be performed two or more times by changing the temperature.

Subsequently, the inter-cell insulation layer 9 is provided on the scribe line section 3. Examples of the method for forming the inter-cell insulation layer 9 include methods which are known in the art without being particularly limited. In detail, the method may be a method where firing is carried out after coating a paste which contains an insulation material which configures the inter-cell insulation layer 9 on the scribe line section 3 using a screen printing method, an ink jet method, or the like, and a sol-gel method or an electrochemical redox reaction may be used instead of the firing. Out of these methods, from the point of view that it is possible to form the inter-cell insulation layer 9 at a low cost, the screen printing method in which paste is used is particularly preferable.

Subsequently, the porous insulation layer 5 is formed on the porous semiconductor layer. Examples of the method for forming the porous insulation layer 5 include methods which are known in the art without being particularly limited. In detail, the method may be a method where firing is carried out after coating a paste which contains an insulation material which configures the porous insulation layer 5 on the porous semiconductor layer using a screen printing method, an ink jet method, or the like, and a sol-gel method, a method using an electrochemical redox reaction, or the like may be used instead of the firing. Out of these methods, from the point of view that it is possible to form the porous insulation layer 5 at a low cost, the screen printing method in which paste is used particularly preferable.

Subsequently, the counter conductive layer 6 is formed on the porous insulation layer 5. The method for forming the counter conductive layer 6 is not particularly limited and may be a vapor deposition method or a printing method. When the counter conductive layer 6 is manufactured by the vapor deposition method, since the counter conductive layer 6 itself becomes porous, it is not necessary to separately form holes through which a coloring dye solution or a carrier transporting material is able to move in the counter conductive layer 6. Here, in a case where the holes are formed in the counter conductive layer 6, it is preferable to use a method which partially evaporates the counter conductive layer 6 using laser light irradiation.

Subsequently, a coloring dye is adsorbed on the porous semiconductor layer. Examples of the method for adsorbing the coloring dye include a method for immersing the porous semiconductor layer in a solution where a coloring dye is dissolved (a solution for adsorbing a coloring dye). It is preferable that the solvent which dissolves the coloring dye be a solvent which is able to dissolve a coloring dye and, in detail, examples include alcohols such as ethanol, ketones such as acetone, ethers such as diethyl ether and tetrahydrofuran, nitrogen compounds such as acetonitrile, halogenated aliphatic hydrocarbons such as chloroform, aliphatic hydrocarbons such as hexane, aromatic hydrocarbons such as benzene, esters such as ethyl acetate, water, or the like. These solvents may be used in a mixture of two or more types.

It is possible to more appropriately adjust the concentration of a coloring dye in the coloring dye adsorption solution according to the coloring dye and the type of the solvent which are used. However, in order to improve the function of adsorbing the coloring dye on the porous semiconductor layer, it is preferable that the coloring dye concentration be as high as possible and, for example, $5x10^{-4}$ mol/l or more is preferable.

Subsequently, the insulation member 8 is provided at a predetermined position. In detail, firstly, the insulation member 8 is manufactured by cutting out a heat sealing film, an ultraviolet curing resin, or the like into a shape which surrounds the periphery of the laminated body (the laminated body is configured by laminating the photoelectric conversion layer 4, the porous insulation layer 5, and the counter conductive layer 6) which is formed on the support material 1. In a case of using a silicone resin, an epoxy resin, or a glass frit as the material of the insulation member 8, it is possible to form a pattern on the insulation member 8 using a dispenser. In a case of using a hot melt resin as the material of the insulation member 8, it is possible to form the insulation member 8 by opening a hole which is patterned in a sheet member formed of a hot melt resin. The insulation member 8 which is formed in this manner is arranged between the transparent electrode substrate 11 and the covering layer 7 such that the transparent electrode substrate 11 and the covering layer 7 are bonded together. Then, the insulation member 8 is fixed to the transparent electrode substrate 11 and the covering layer 7 by heating or ultraviolet irradiation.

Subsequently, a carrier transporting material is introduced from introduction holes which are provided in advance in the covering layer 7. When a portion interposed between the conductive layer 2 and the covering layer 7 in the

insulation member 8 is filled with the carrier transporting material, the introduction holes are sealed using an ultraviolet curing resin. Due to the charging of the carrier transporting material, a carrier transporting layer is formed on the counter conductive layer 6 and the carrier transporting material is held on the photoelectric conversion layer 4 and the porous insulation layer 5. Due to this, the photoelectric conversion element 10 shown in Fig. 1 is manufactured.

<Photoelectric Conversion Module>

Fig. 2 is a schematic cross-sectional diagram of a portion of the photoelectric conversion module according to the present invention.

In the photoelectric conversion module 20 shown in Fig. 2, three photoelectric conversion elements are connected in series. In detail, three of the conductive layers 2 are provided on one support material 21 to be partitioned by the scribe line section 3 and a transparent electrode substrate 31 is configured due to this. The photoelectric conversion layer 4 which is configured by a coloring dye or the like being adsorbed on the porous semiconductor layer, the porous insulation layer 5, the counter conductive layer 6, and the carrier transporting layer are provided on each of the conductive layers 2. In the photoelectric conversion module 20, the counter conductive layer 6 of one photoelectric conversion element out of adjacent photoelectric conversion elements passes over the inter-cell insulation layer 9, extends toward the conductive layer 2 of the other photoelectric conversion element, and is electrically connected with the conductive layer 2. Due to this, the adjacent photoelectric conversion elements are connected in series.

The inter-cell insulation layer 9 is provided on the scribe line section 3. Due to this, in the photoelectric conversion module 20 shown in Fig. 2, since it is possible to suppress an increase in the reverse current which is generated between the regions which are divided by the scribe line section 3 during heat loading even when the line width D2 of the scribe line section 3 in each of the photoelectric conversion elements is 60 μm or more, the photoelectric conversion efficiency is improved with respect to external environmental factors such as heat. Accordingly, it is possible to prevent changes in the photoelectric conversion efficiency with respect to the passage of time. When the line width D2 of the scribe line section 3 in each of the photoelectric conversion elements is preferably 80 μm or more to 300 μm or less, more preferably 100 μm or more to 200 μm or less, it is possible to further suppress an increase in the reverse current between the regions which are divided by the scribe line section 3. Accordingly, since the photoelectric conversion efficiency is further improved with respect to external environmental factors such as heat, it is possible to further prevent changes in the photoelectric conversion efficiency with respect to the passage of time.

In the photoelectric conversion module 20 shown in Fig. 2, one covering layer 27 is provided on the counter conductive layer 6 so as to oppose the support material 21 and the insulation member 8 or a sealing member 32 is provided between the support material 21 and the covering layer 27. The photoelectric conversion elements on both ends are sealed by the support material 21, the covering layer 27, the insulation member 8, and the sealing member 32 and the photoelectric conversion element in the center is sealed by the support material 21, the covering layer 27, and two of the insulation members 8. The carrier transporting layer is formed by the carrier transporting material in a region which is inside the sealing member 32 and which is positioned between the support material 21 and the covering layer 27; however, since adjacent photoelectric conversion elements are partitioned by the insulation member 8, it is possible to prevent the carrier transporting material from moving back and forth between the adjacent photoelectric conversion elements.

In this manner, the insulation member 8 has a function of partitioning adjacent photoelectric conversion elements. Here, since the counter conductive layer 6 passes over the inter-cell insulation layer 9 from the first region and extends to the second region, the insulation member 8 is provided above the counter conductive layer 6 without directly coming into contact with the scribe line section 3. In addition, as described above in <Inter-cell Insulation Layer>, when the insulation member 8 is provided on the inter-cell insulation layer 9 to interpose the counter conductive layer 6, in other words, when a part of the insulation member 8 is configured at the inter-cell insulation layer 9, it is possible to reduce the size of the photoelectric conversion elements 10 and thus, it is possible to improve the ratio of active area to aperture area of the photoelectric conversion elements in the photoelectric conversion module 20.

The support material 21 is preferably formed of a material which has a light transmitting property in the same manner as the support material 1 in the photoelectric conversion element 10 shown in Fig. 1 and, in detail, is preferably formed of a material which is able to be used as the material of the support material 1. It is preferable that the covering layer 27 be formed of a material which is able to be used as the material of the covering layer 7 in the photoelectric conversion element 10 shown in Fig. 1. The sealing member 32 may be formed of substantially the same material as the insulation member 8 or may be formed of a material which is different from the insulation member 8 (for example, a material which does not have an insulation property).

In the photoelectric conversion module 20 shown in Fig. 2, it is preferable that a collecting electrode (which is not shown in the diagram) be provided outside of the sealing member 32 on the support material 1 and that the collecting electrode be in contact with the conductive layers 2 of the photoelectric conversion elements which are positioned at both ends. Due to this, it is possible to easily extract current from the photoelectric conversion module 20 to the outside.

In the photoelectric conversion module 20 shown in Fig. 2, the photoelectric conversion element which is positioned in the center is equivalent to the photoelectric conversion element 10 shown in Fig. 1 and the photoelectric conversion elements which are positioned at both ends have a member which seals the carrier transporting layer or the like which is different from that of the photoelectric conversion element 10 shown in Fig. 1. However, in the photoelectric conversion module 20 shown in Fig. 2, the photoelectric conversion elements 10 shown in Fig. 1 may be connected in series. In other words, the insulation member 8 may be used instead of the sealing member 32.

Here, in the photoelectric conversion module according to the present invention, the number of the photoelectric conversion elements which configure the photoelectric conversion module 20 is not limited to three.

Examples

The present invention will be further described in detail using Examples and Comparative Examples; however, the present invention is not limited to these Examples and Comparative Examples.

<Examples 1 to 7 and Comparative Examples 1 to 9>

<Manufacturing Solar Cell>

The transparent electrode substrate 11 (a glass with an $SnO_2$ film manufactured by Nippon Sheet Glass Co., Ltd.) where the conductive layer 2 formed of $SnO_2$ was formed on the support material 1 formed of glass was prepared. The size of the transparent electrode substrate 11 was 30 mm x 30 mm x 1.0 mm (thickness). A part of the conductive layer 2 of the transparent electrode substrate 11 was cut by a laser scribe.

At this time, in Examples 1 to 7, the line width D2 of the scribe line section 3 was set to D2=60, 70, 80, 90, 100, 150, and 200 μm and the inter-cell insulation layer 9 was formed on the scribe line section 3. On the other hand, in Comparative Example 1, the line width D2 of the scribe line section 3 was set to D2=50 μm and the inter-cell insulation layer 9 was formed on the scribe line section 3. In addition, in Comparative Examples 2 to 8, the line width D2 of the scribe line section 3 was set to D2=60, 70, 80, 90, 100, 150, and 200 μm and the inter-cell insulation layer 9 was not formed on the scribe line section 3.

Next, using a screen printing plate which has a pattern for the inter-cell insulation layer 9 and a screen printing machine (Model number: LS-150 manufactured by Newlong Seimitsu Kogyo Co., Ltd.), commercially available glass paste (with an average particle diameter of 18 nm manufactured by NORITAKE Co., Ltd.) was applied to the conductive layer 2 and levelling was carried out at room temperature for one hour. After that, the obtained coated film was dried in an oven which was set to 80°C for 20 minutes and then fired in air for 60 minutes using a firing furnace (Model number: KDF P-100 manufactured by Denken Co., Ltd.) which was set to 500°C. As a result, a porous semiconductor layer was obtained with the film thickness of 15 μm.

Next, using the screen printing machine, a paste which includes zirconia particles (average particle diameter 50 nm) was applied to the porous semiconductor layer. After that, the porous insulation layer 5 was formed by carrying out firing at 500°C for 60 minutes. Here, when the pore diameter of the porous insulation layer 5 was measured using a BET measuring machine (Product number: Autosorb-1 manufactured by Yuasa Ionics Co., Ltd.), the diameter thereof was 90 μm.

Next, using a mask where a predetermined pattern was formed and a vapor deposition apparatus (Model number: EVD500A manufactured by Canon Anelva Corp.), titanium with a film thickness of 400 nm was deposited on the porous insulation layer 5 at a vapor deposition rate of 8 angstroms/s. Due to this, the counter conductive layer 6 was obtained.

Next, using a mask where a predetermined pattern was formed and a vapor deposition apparatus (Model number: EVD500A manufactured by Canon Anelva Corp.), a Pt film was formed on the counter conductive layer 6 at a vapor deposition rate of 4 angstroms/s. Due to this, a catalyst layer was formed on the counter conductive layer 6 and a laminated body (the laminated body was configured by laminating the porous semiconductor layer, the porous insulation layer 5, and the counter conductive layer 6, and the catalyst layer in sequence) was formed on the transparent electrode substrate 11. Here, the size and the position of the catalyst layer are respectively the same as the size and the position of the porous semiconductor layer.

Next, the laminated body was immersed in a solution for adsorbing a coloring dye which was prepared in advance at room temperature for 100 hours. After that, the laminated body was dried at approximately 60°C for approximately 5 minutes after cleaning with ethanol. Due to this, the coloring dye was adsorbed on the porous semiconductor layer.

Here, the solution for adsorbing a coloring dye was prepared by dissolving the coloring dye (Product name: Ruthenium 620 1H3TBA manufactured by Solaronix SA) of the above chemical formula (1) in a mixed solvent of acetonitrile and t-butanol at a volume ratio of 1:1 such that the concentration was $4x10^{-4}$ mol/l.

Next, using a heat sealing film (Himilan 1855 manufactured by Du Pont Kabushiki Kaisha) which was cut out into a shape which surrounded the periphery of the laminated body, the transparent electrode substrate 11 where the laminated body was formed and the covering layer 7 formed of glass were bonded. After that, heating was carried out in an oven which was set to approximately 100°C for 10 minutes. Due to this, the heat sealing film was melted to become the insulation member 8 and the melted heat sealing film was pressure-bonded with each of the transparent electrode substrate 11 and the covering layer 7.

Next, an electrolytic solution which was prepared in advance was introduced from introduction holes for an electrolytic solution which were formed in advance on the covering layer 7. When the space which was formed by the transparent electrode substrate 11, the covering layer 7, and the insulation member 8 was filled with the electrolytic solution, the introduction holes for the electrolytic solution were sealed using an ultraviolet curing resin (Model number: 31X-101 manufactured by ThreeBond Holdings Co., Ltd.). Due to this, the photoelectric conversion elements (single cells) were completed.

Here, the electrolytic solution was prepared according to the method which will be described below. LiI (redox species manufactured by Sigma-Aldrich Co., LLC.) was dissolved in acetonitrile as a solvent such that the concentration was 0.1 mol/l and $I_2$ (redox species manufactured by Kishida Chemical Co., Ltd.) was dissolved such that the concentration was 0.01 mol/l. Furthermore, t-butylpyridine (additive manufactured by Sigma-Aldrich Co., LLC.) was dissolved in the acetonitrile described above such that the concentration was 0.5 mol/l and dimethyl propyl imidazole iodide (manufactured by Shikoku Chemicals Corp.) was dissolved such that the concentration was 0.6 mol/l.

A collecting electrode section was formed by coating Ag paste (trade name: Dotite manufactured by Fujikura Kasei Co., Ltd.) on the transparent electrode substrate 11 of the obtained photoelectric conversion element. The photoelectric conversion elements in Examples 1 to 7 and Comparative Examples 1 to 9 were manufactured as described above.

<Evaluation Method and Results>

A black mask where the area of an opening section was 1.0 $cm^2$ was disposed on the light receiving surface of the photoelectric conversion elements in Examples 1 to 7 and Comparative Examples 1 to 9. Then, the photoelectric conversion efficiency ($\eta$) was measured by emitting light with an intensity of 1 $kW/m^2$ (AM1.5 solar simulator) onto the photoelectric conversion elements.

In addition, changes in the photoelectric conversion efficiency over time were measured by inserting the photoelectric conversion elements in Examples 1 to 7 and Comparative Examples 1 to 9 where the black mask was disposed, into a thermostatic tank at 85°C and applying heat stress to the photoelectric conversion elements. A sandwich cell (a sandwich cell is formed by a negative pole and a positive pole being separately produced and bonded together) was prepared as a reference cell and changes in the photoelectric conversion efficiency with respect to the passage of time were also measured. Then, the photoelectric conversion efficiency of the photoelectric conversion elements in Examples 1 to 7 and Comparative Examples 1 to 9 was divided by the photoelectric conversion efficiency of the sandwich cell to obtain the holding ratio of the photoelectric conversion efficiency with respect to the sandwich cell. This has the meaning that the photoelectric conversion efficiency is better as the holding ratio of the photoelectric conversion efficiency with respect to the sandwich cell is higher. Here, in Examples 1 to 7 and Comparative Examples 1 to 9, the holding ratio of the photoelectric conversion efficiency with respect to the sandwich cell was obtained by setting the experiment time to 500 hours.

Fig. 3 is a graph which shows the results of investigating a relationship between the line width D2 of the scribe line section 3 and the holding ratio (%) of the photoelectric conversion efficiency of the photoelectric conversion element with respect to the sandwich cell. As shown in Fig. 3, the holding ratio of the photoelectric conversion efficiency with respect to the sandwich cell starts to increase when the line width D2 of the scribe line section 3 is 60 $\mu$m or more and the holding ratio of the photoelectric conversion efficiency with respect to the sandwich cell is 90% or more when the line width D2 of the scribe line section 3 is 70 $\mu$m or more.

As is clear from Fig. 3, in order to set the holding ratio of the photoelectric conversion efficiency with respect to the sandwich cell to 90% or more, it is necessary to set the line width D2 of the scribe line section 3 to 90 $\mu$m or more in a case where the inter-cell insulation layer 9 is not provided; however, the line width D2 of the scribe line section 3 may be set to 70 $\mu$m or more in a case where the inter-cell insulation layer 9 is provided. Therefore, it is understood that it is possible to prevent a decrease in the photoelectric conversion efficiency with respect to the passage of time even when the line width D2 of the scribe line section 3 is reduced compared to a case where there is no inter-cell insulation layer on the scribe line section and that the ratio of active area to aperture area of the solar cell is improved as a result.

<Examples 8 to 9 and Comparative Examples 9 and 10>

<Manufacturing Photoelectric Conversion Module>

The photoelectric conversion module shown in Fig. 2 was manufactured.

Firstly, the transparent electrode substrate 31 (trade name: glass with $SnO_2$ film, length 60 mm x width 37 mm manufactured by Nippon Sheet Glass Co., Ltd.) where the conductive layer ($SnO_2$ film) 2 was formed on the surface of the support material 21 was prepared. The scribe line sections 3 were formed so as to extend in the length direction of the transparent electrode substrate 31 and be parallel to each other by removing parts of the conductive layer 2 on the surface of the transparent electrode substrate 31 using a laser scribe. The conductive layer 2 was divided into three regions due to the forming of the scribe line sections 3.

Here, in Examples 8 to 9, the line width D2 of the scribe line section 3 was set to D2=80 and 100 μm and the inter-cell insulation layer 9 was formed on the scribe line section 3. On the other hand, in Comparative Examples 9 and 10, the line width D2 of the scribe line section 3 was set to D2=80 and 100 μm and the inter-cell insulation layer 9 was not formed on the scribe line section 3.

Next, a porous semiconductor layer was formed according to Example 1 described above. In detail, one porous semiconductor layer with a size where the film thickness was 25 μm, the width was 5 mm, and the length was 50 mm was formed by setting a position at 6.9 mm from the left end of the transparent electrode substrate 31 as the center. A second porous semiconductor layer was formed by setting a position at 6.9 mm from the center of the first porous semiconductor layer as the center and a third porous semiconductor layer was formed by setting a position at 6.9 mm from the center of the second porous semiconductor layer as the center. Here, the sizes of the porous semiconductor layers were the same.

The porous insulation layer 5 was formed on each of the porous semiconductor layers according to Example 1 described above.

Next, the counter conductive layer 6 was formed on each of the porous insulation layers 5 according to Example 1 described above. One of the counter conductive layers 6 with a size where the width was 5.6 mm and the length was 50 mm was formed by setting a position at 7.2 mm from the left end of the transparent electrode substrate 31 as the center. A second counter conductive layer 6 was formed by setting a position at 7 mm from the center of the first counter conductive layer 6 as the center and a third counter conductive layer 6 was formed by setting a position at 7 mm from the center of the second counter conductive layer 6 as the center. Here, the sizes of the counter conductive layers 6 were the same.

Next, a catalyst layer formed of Pt was formed on each of the counter conductive layers 6 according to Example 1 described above. Here, the size and the position of the catalyst layer were the same as the size and the position of the porous semiconductor layer respectively.

The photoelectric conversion layer 4 was formed by immersing the laminated body obtained in this manner in the solution for adsorbing a coloring dye used in Example 1 described above at room temperature for 120 hours and adsorbing the coloring dye on the porous semiconductor layer.

Next, an ultraviolet curing resin (31X-101 manufactured by ThreeBond Holdings Co., Ltd.) was applied between the adjacent laminated bodies and on the periphery of the cell using a dispenser (Ultrasaver manufactured by Nordson EFD Corp.). After bonding a glass substrate with a length of 60 mm x a width of 30 mm as the covering layer 27 with the ultraviolet curing resin, ultraviolet rays were emitted to the ultraviolet curing resin using an ultraviolet lamp (Novacure manufactured by Nordson EFD Corp.). Due to this, the insulation member 8 and the sealing member 32 were formed by curing the ultraviolet curing resin.

After that, the same electrolytic solution as in Example 1 was introduced from electrolytic solution introduction holes provided in advance in the glass substrate. When the space which was formed by the transparent electrode substrate 31, the covering layer 27, and the insulation member 8 or the sealing member 32 was filled with the electrolytic solution, the electrolytic solution introduction holes were sealed using the ultraviolet curing resin (model number: 31X-101 manufactured by ThreeBond Holdings Co., Ltd.).

A collecting electrode was formed by coating Ag paste (trade name: Dotite manufactured by Fujikura Kasei Co., Ltd.) on the surface of the support material 21. Due to this, the photoelectric conversion module was completed.

<Evaluation Method and Results>

A black mask was disposed on the light receiving surface of the photoelectric conversion module in Examples 8 to 9 and Comparative Examples 9 and 10. Then, the photoelectric conversion efficiency was measured by emitting light with an intensity of 1 $kW/m^2$ (AM1.5 solar simulator) to the photoelectric conversion module. In addition, the holding ratio of the photoelectric conversion efficiency with respect to the sandwich cell was obtained according to Example 1 described above.

The photoelectric conversion efficiency in Example 8 was higher than that in Example 9. It may be considered that the reason is that the ratio of active area to aperture area in Example 8 was higher than that in Example 9. For the same reason, the photoelectric conversion efficiency in Example 9 was higher than the photoelectric conversion efficiency in Example 10.

Fig. 4 is a graph which shows the results of investigating the relationship between the line width D2 of the scribe line section 3 and the holding ratio (%) of photoelectric conversion efficiency of a photoelectric conversion module with respect to a sandwich cell. Regarding the holding ratio of photoelectric conversion efficiency with respect to a sandwich cell, the holding ratios in Example 8 and Example 3 were the same, the holding ratios in Example 9 and Example 5 were the same, the holding ratios in Comparative Example 9 and Comparative Example 4 were the same, and the holding ratios in Comparative Example 19 and Comparative Example 6 were the same. In addition, the holding ratio of the photoelectric conversion efficiency with respect to the sandwich cell in Example 8 (D2=80 μm, the inter-cell insulation layer 9 was formed) was the same as the holding ratio of the photoelectric conversion efficiency with respect to the sandwich cell in Comparative Example 10 (D2=100 μm, the inter-cell insulation layer 9 was not formed). Thus, it is understood that when the inter-cell insulation layer 9 is formed, not only is it possible to prevent a decrease in the holding ratio of the photoelectric conversion efficiency with respect to the passage of time, but that it is also possible to prevent a decrease in the ratio of active area to aperture area in the photoelectric conversion module.

The embodiments and Examples described herein are illustrative in all respects and should be considered as not limiting. The range of the present invention is shown by the scope of the claims and not the above description and it is intended that meanings equivalent to the scope of the claims and all changes within the scope of the claims be included. Reference Signs List

| | |
|---|---|
| 1, 21 | SUPPORT MATERIAL |
| 2 | CONDUCTIVE LAYER |
| 3 | SCRIBE LINE SECTION |
| 4 | PHOTOELECTRIC CONVERSION LAYER |
| 5 | POROUS INSULATION LAYER |
| 6 | COUNTER CONDUCTIVE LAYER |
| 7, 27 | COVERING LAYER |
| 8 | INSULATION MEMBER |
| 9 | INTER-CELL INSULATION LAYER |
| 10 | PHOTOELECTRIC CONVERSION ELEMENT |
| 11, 31 | TRANSPARENT ELECTRODE SUBSTRATE |
| 20 | PHOTOELECTRIC CONVERSION MODULE |
| 32 | SEALING MEMBER |

## Claims

**1.** A photoelectric conversion element comprising:

a support material formed of a material with a light transmitting property; and
a conductive layer, a photoelectric conversion layer which includes a porous semiconductor layer, a porous insulation layer, and a counter conductive layer, which are provided in sequence on the support material,
wherein respective interval portions in the porous semiconductor layer, the porous insulation layer, and the counter conductive layer are filled with a carrier transporting material,
a first region where a photoelectric conversion layer is provided on the conductive layer and a second region where a photoelectric conversion layer is not provided on the conductive layer interpose therebetween a scribe line section which is configured without the conductive layer being provided on the support material,
an inter-cell insulation layer is provided on the scribe line section,
the counter conductive layer is connected with the conductive layer in the second region by extending to the second region by passing over the inter-cell insulation layer from the first region, and
the line width of the scribe line section is 60 μm or more.

**2.** The photoelectric conversion element according to Claim 1,
wherein the line width of the scribe line section is 500 μm or less.

**3.** The photoelectric conversion element according to Claims 1 or 2,

wherein a width D1 (μm) of the inter-cell insulation layer satisfies a relational expression of $D1>D2+100$ μm using a line width D2 (μm) of the scribe line section.

**4.** The photoelectric conversion element according to any one of Claims 1 to 3, wherein the carrier transporting material is an electrolytic solution.

**5.** The photoelectric conversion element according to any one of Claims 1 to 4, wherein the porous insulation layer is in contact with the inter-cell insulation layer rather than the scribe line section.

**6.** The photoelectric conversion element according to any one of Claims 1 to 5, wherein the pore diameter of the porous insulation layer is 50 μm or more.

**7.** The photoelectric conversion element according to any one of Claims 1 to 6, wherein the inter-cell insulation layer includes at least a silicon oxide.

**8.** The photoelectric conversion element according to any one of Claims 1 to 7, wherein the pore diameter of the inter-cell insulation layer is 100 nm or less.

**9.** A photoelectric conversion module provided with the photoelectric conversion element according to any one of Claims 1 to 8,
wherein a photoelectric conversion layer which includes a porous semiconductor layer, a porous insulation layer, and a counter conductive layer are provided in sequence on a conductive layer in the second region, and
an insulation member which stops movement of the carrier transporting material is provided between the photoelectric conversion layer, the porous insulation layer, and the counter conductive layer which are provided on the conductive layer in the first region, and the photoelectric conversion layer, the porous insulation layer, and the counter conductive layer which are provided on the conductive layer in the second region.

**10.** The photoelectric conversion module according to Claim 9, wherein the inter-cell insulation layer configures a part of the insulation member.

FIG. 1

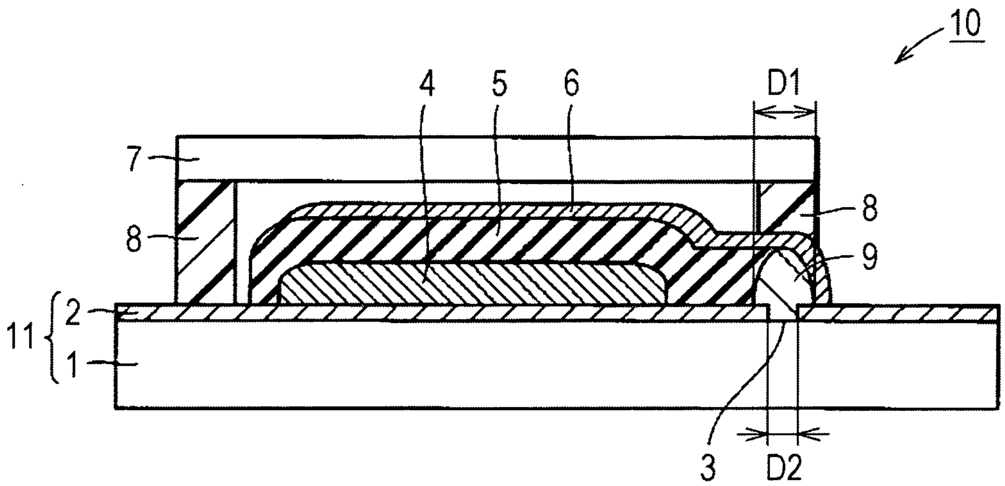

FIG. 2

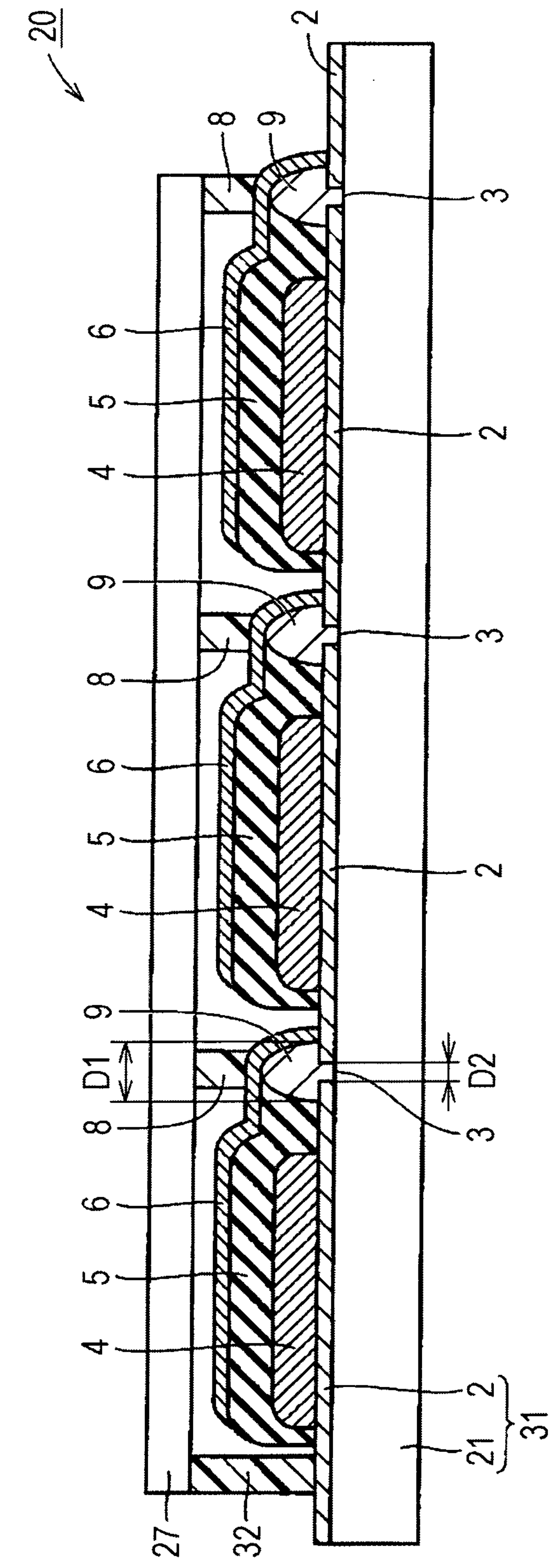

FIG. 3

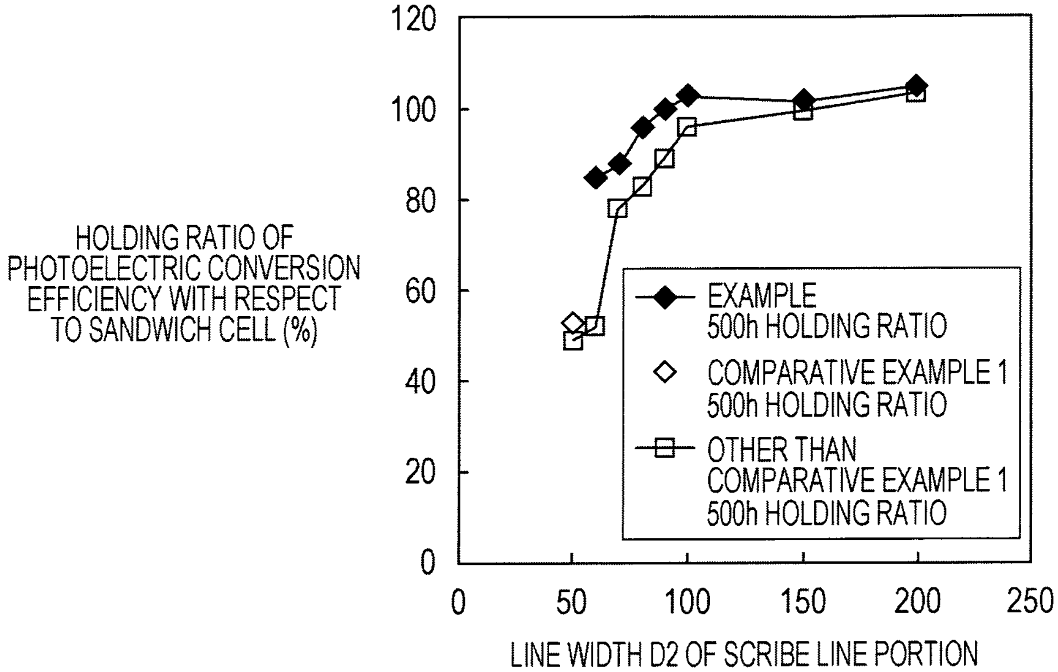
120
100
80
60
40
20
0
HOLDING RATIO OF PHOTOELECTRIC CONVERSION EFFICIENCY WITH RESPECT TO SANDWICH CELL (%)
EXAMPLE 500h HOLDING RATIO
COMPARATIVE EXAMPLE 1 500h HOLDING RATIO
OTHER THAN COMPARATIVE EXAMPLE 1 500h HOLDING RATIO
0
50
100
150
200
250
LINE WIDTH D2 OF SCRIBE LINE PORTION

FIG. 4

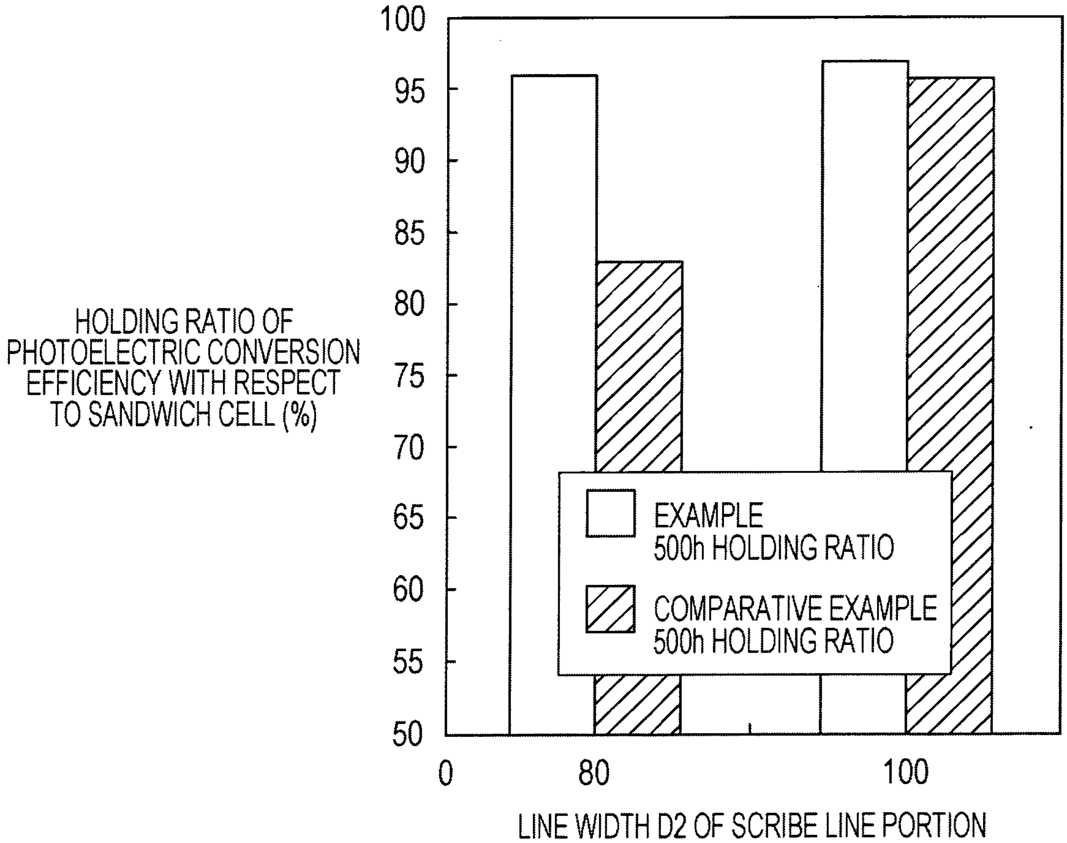
100
95
90
85
80
75
70
65
60
55
50
HOLDING RATIO OF PHOTOELECTRIC CONVERSION EFFICIENCY WITH RESPECT TO SANDWICH CELL (%)
EXAMPLE 500h HOLDING RATIO
COMPARATIVE EXAMPLE 500h HOLDING RATIO
0
80
100
LINE WIDTH D2 OF SCRIBE LINE PORTION

## INTERNATIONAL SEARCH REPORT

International application No. PCT/JP2013/062039

A. CLASSIFICATION OF SUBJECT MATTER
*H01M14/00*(2006.01)i, *H01L31/04*(2006.01)i

According to International Patent Classification (IPC) or to both national classification and IPC

B. FIELDS SEARCHED

Minimum documentation searched (classification system followed by classification symbols)
H01M14/00, H01L31/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2008-016351 A (Sharp Corp.), 24 January 2008 (24.01.2008), entire text; all drawings (Family: none) | 1-10 |
| X | WO 2011/001815 A1 (Sharp Corp.), 06 January 2011 (06.01.2011), entire text; all drawings & US 2012/0103400 A1 & EP 2451005 A1 & CN 102460821 A | 1-10 |
| A | JP 2007-194039 A (Sharp Corp.), 02 August 2007 (02.08.2007), entire text; all drawings & US 2010/0012166 A1 & EP 1976051 A1 & WO 2007/083461 A1 & CN 101361218 A | 1-10 |

☒ Further documents are listed in the continuation of Box C. ☐ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| | |
|---|---|
| Date of the actual completion of the international search<br>25 June, 2013 (25.06.13) | Date of mailing of the international search report<br>02 July, 2013 (02.07.13) |
| Name and mailing address of the ISA/<br>Japanese Patent Office<br>Facsimile No. | Authorized officer<br><br>Telephone No. |

Form PCT/ISA/210 (second sheet) (July 2009)

**INTERNATIONAL SEARCH REPORT**

International application No.
PCT/JP2013/062039

C (Continuation). DOCUMENTS CONSIDERED TO BE RELEVANT

| Category* | Citation of document, with indication, where appropriate, of the relevant passages | Relevant to claim No. |
|---|---|---|
| A | WO 2008/004553 A1 (Sharp Corp.), 10 January 2008 (10.01.2008), entire text; all drawings & US 2010/0071743 A1 & EP 2043190 A1 & CN 101485037 A | 1-10 |
| A | JP 2009-043481 A (Sharp Corp.), 26 February 2009 (26.02.2009), paragraphs [0084] to [0094]; fig. 18 (Family: none) | 1-10 |
| A | JP 2012-009374 A (Sharp Corp.), 12 January 2012 (12.01.2012), entire text; all drawings (Family: none) | 1-10 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 1220380 A
- WO 1997016838 A
- JP 2002367686 A
- JP 2007194039 A